**Europäisches Patentamt**

**European Patent Office**

**Office européen des brevets**

(19)

(11) Veröffentlichungsnummer : **0 158 230**
**B1**

# EUROPÄISCHE PATENTSCHRIFT

(12)

(45) Veröffentlichungstag der Patentschrift :
29.07.87

(21) Anmeldenummer : 85103709.3

(22) Anmeldetag : 27.03.85

(51) Int. Cl.⁴ : **H 04 R 17/00**, H 04 R 1/04,
**H 05 K 3/34**

(54) Piezoelektrisch-akustischer Wandler für elektroakustische Kapseln mit Konstruktionsausführung für die Montage.

(30) Priorität : 11.04.84 DE 3413697

(43) Veröffentlichungstag der Anmeldung :
16.10.85 Patentblatt 85/42

(45) Bekanntmachung des Hinweises auf die Patenterteilung : 29.07.87 Patentblatt 87/31

(84) Benannte Vertragsstaaten :
AT BE CH DE FR GB IT LI LU NL SE

(56) Entgegenhaltungen :
EP-A- 0 007 436
FR-A- 2 530 108
LU-A-    67 103
US-A- 3 500 013

(73) Patentinhaber : **Siemens Aktiengesellschaft Berlin
und München**
**Wittelsbacherplatz 2**
**D-8000 München 2 (DE)**

(72) Erfinder : **Edinger, Egon, Dipl.-Ing. (FH)**
**Buchenstrasse 3**
**D-8033 Krailling (DE)**
Erfinder : **Pedall, Friedrich, Dipl.-Ing. (FH)**
**Johann-Clanze-Strasse 53**
**D-8000 München 70 (DE)**

## Beschreibung

Die Erfindung betrifft piezoelektrisch-akustische Wandler für elektroakustische Kapseln mit zwei Anschlußelementen in Form von Anschlußbändchen bzw. -drähten für den Wandler, von denen das eine an der kleberseitigen Elektrode der Piezokeramik kontaktiert und das zweite an der anderen Elektrode aufgelötet ist, und Vorrichtungen zum Anlöten der Anschlußbändchen auf den Leiterbahnen einer Verstärkerflachbaugruppe und zum Montieren dieser Flachbaugruppe auf der Trägerplatte.

Piezoelektrisch-akustische Wandler werden in Fernsprechgeräten, vorzugsweise in Sprechkapseln (Mikrofonen), Hörkapseln und Tonrufkapseln, eingebaut. Mit Ausnahme eines Hörkapseltyps hat der Wandler stets zwei Anschlußbändchen : ein Bändchen ist an der kleberseitigen Elektrode der Piezokeramik druckkontaktiert (siehe DE-A-28 20 403) und das zweite ist an der anderen Elektrode aufgelötet.

Bisher werden die beiden Anschlußbändchen der Wandlerplatte manuell unter Zugabe von Lötzinn an Griplet-Lötnieten auf der Leiterplatten-Bauteileseite angelötet. Hierzu müssen die Trennplatte, die Silikonringe, die Wandlerplatte, der Träger und die Verstärkerbaugruppe vormontiert werden. Durch das Aufbringen eines Kunststoffringes wird der elektrische Kurzschluß zwischen Metallgehäuse und Anschlußbändchen verhindert. Dieses Montage- und Lötverfahren ist teuer, störanfällig und nicht automatisierbar (EP-A-0 007 436).

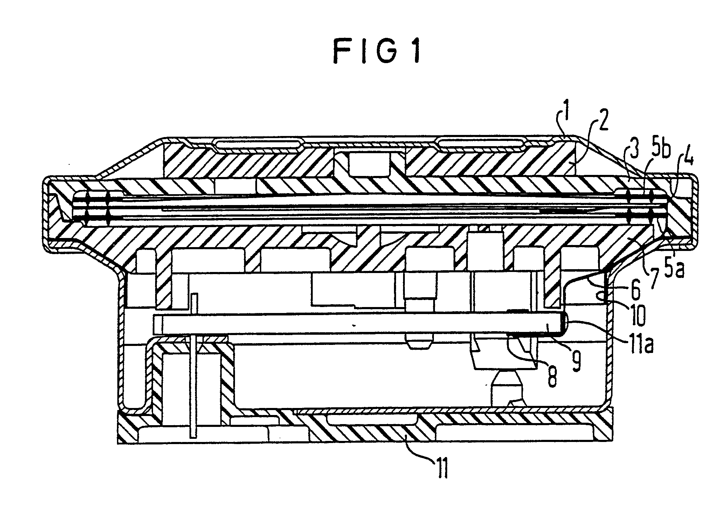

In der Figur 1 ist der bisherige Aufbau einer Sprechkapsel dargestellt. Mit 1 ist das Gehäuse bezeichnet, unter dessen Oberfläche ein Dämpfungsring 2 angeordnet ist. Unter dem Dämpfungsring liegt eine Trennplatte 3. Der Wandler besteht aus einer Wandlerplatte 4 aus elektrisch leitendem Material und einer scheibenförmigen Piezokeramik, welche beidseitig und ganzflächig mit Elektroden versehen ist. Die mit den Elektroden versehene Piezokeramik ist mit der Wandlerplatte 4 durch Kleben fest verbunden. Der Wandler ist mit Hilfe von zwei Silikonringen 5a und 5b gehalten. Das druckkontaktierte Anschlußbändchen ist in der gezeichneten Schnittebene nicht dargestellt. Das aufgelötete Anschlußbändchen 6 wird zwischen Wandlerplatte 4 und Silikonring 5 zwischen einem Träger 7 aus Kunststoff und dem Gehäuse aus Metall zur Bauteilseite 8 einer Verstärkerbaugruppe 9 geführt und dort an Griplet-Lötniete 8 angelötet. Mit 10 ist ein Kunststoffring bezeichnet, der die beiden Anschlußbändchen gegen das Metallgehäuse des Piezomikrofons kurzschlußfest absichert. Im unteren Bereich des Gehäuses ist ein Isolierstoffkörper 11 vorgesehen.

Der Erfindung liegt die Aufgabe zugrunde, den eingangs definierten und in Figur 1 dargestellten piezoelektrisch-akustischen Wandler derart zu verbessern, daß ein vollautomatisches Anlöten der beiden Anschlußbändchen der akustischelektrischen Wandlerplatte an die Verstärkerbaugruppe des Mikrofons ermöglicht wird. Ferner sind die Anschlußbändchen mit einem Etikett 10a anstelle des Kunststoffringes kurzschlußsicher gegen das Metallgehäuse zu isolieren.

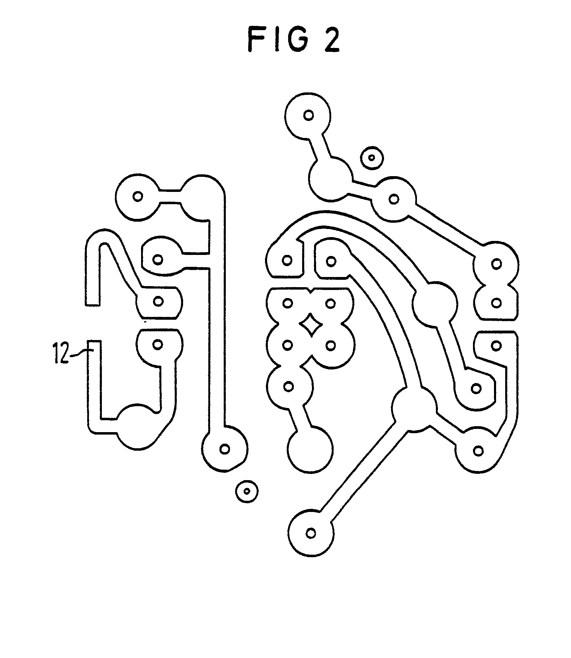

Diese Aufgabe wird — wie in Figur 2 dargestellt — dadurch gelöst, daß die nicht mit der Wandlerplatte verbundenen Enden dieser Anschlußbändchen auf Leiterbahnen einer Verstärkerflachbaugruppe angelötet sind. Damit wird erreicht, daß die bisher benötigten teuren Griplet-Lötnieten und der für die Fixierung der Anschlußbändchen notwendige Silikonkleber entfallen können. Die Zugabe von Lötzinn und Flußmittel während des Lötvorganges ist ebenfalls nicht mehr notwendig, da das während des Schwallvorganges aufgebrachte Zinn und die Flußmittelreste für den Lötvorgang ausreichen.

Nach einer Weiterbildung der Erfindung lassen die Anschlußstellen für die Bändchen einen Toleranzbereich für das Anlöten zu.

Voraussetzung für diese Art der automatengerechten Lötung der Anschlußbändchen ist eine erfindungsgemäß geänderte Montagefolge, die nur mit Hilfe eines Werkstückträgers bzw. mit einer entsprechenden Werkstückaufnahme möglich ist. Vorrichtungen dieser Art sind Gegenstand der Unteransprüche 3 bis 9. Die Trennplatte wird hierbei so in dem notwendigen Werkstückträger fixiert, daß die Leiterbahnseite frei zugänglich ist. Silikonringe und Wandlerplatte werden ebenfalls auf dem Werkstückträger vormontiert. Die beiden Anschlußbändchen kreuzen hierbei die Leiterbahn, an der die Bändchen angelötet werden. Mit Hilfe von zwei temperaturgeregelten Bügellöteinrichtungen werden die Bändchen in einem Reflow-Lötvorgang angelötet. Anschließend wird der Träger von oben auf die Verstärkerbaugruppe aufgedrückt. Verstärkerbaugruppe und Träger werden geschwenkt und in die Trennplatte eingedrückt.

In einem weiteren Arbeitsvorgang werden dann erfindungsgemäß die beiden Anschlußbändchen durch ein automatisch aufgebrachtes Etikett gegen das Metallgehäuse des Piezomikrofons kurzschlußfest abgesichert.

Die Erfindung wird anhand der Figuren 2 bis 7 erläutert. Es zeigen :

Figur 1 ein bekanntes Piezo-Transistormikrofon im Schnitt,

Figur 2 die Leiterbahnseite der Verstärkerflachbaugruppe,

Figur 3 den Querschnitt einer Transistormikrofonkapsel mit auf der Leiterbahn angelöteten Anschlußbändchen und Isolieretikett,

Figur 4 einen Werkstückträger zur Aufnahme der Einheit konstruktive Halteelemente und Wandlerplatte sowie Verstärkerflachbaugruppe,

Figur 5 die Vorrichtung nach Figur 4 zusätzlich mit Aushebevorrichtung und Reflowlötkopf,

Figur 6 in Ergänzung zu Figur 4 eine Trägerzuführeinrichtung und -Trägermontagestempel und

Figur 7 das teilmontierte Transistormikrofon nach einem Schwenk- und Montagevorgang durch eine nicht dargestellte Zusatzvorrichtung.

In der Figur 1 ist — wie bereits ausgeführt — ein Transistormikrofon im Schnitt gezeigt, bei dem die Anschlußbändchen über Griplet-Lötnieten 8 an der Flachbaugruppe 9 kontaktiert sind.

Im linken Teil der Figur 2 sind die Leiterbahnen 12 zu erkennen, auf die die Anschlußbändchen in einem gewissen Toleranzbereich aufgelötet werden können.

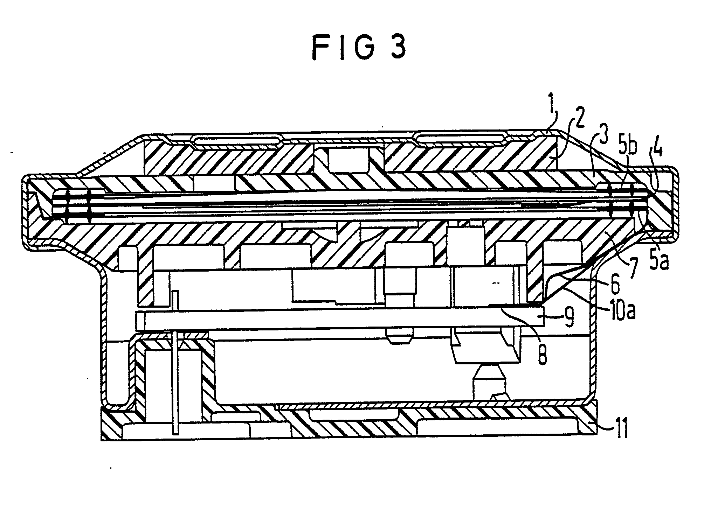

Die Figur 3 unterscheidet sich von der Figur 1 durch Wegfall der Griplet-Lötnieten 8 und die Kontaktierung der Bändchen auf die Leiterbahnen 12. Außerdem ist das Klebeetikett 10a zur Isolierung der Bändchen gegenüber dem Metallgehäuse dargestellt.

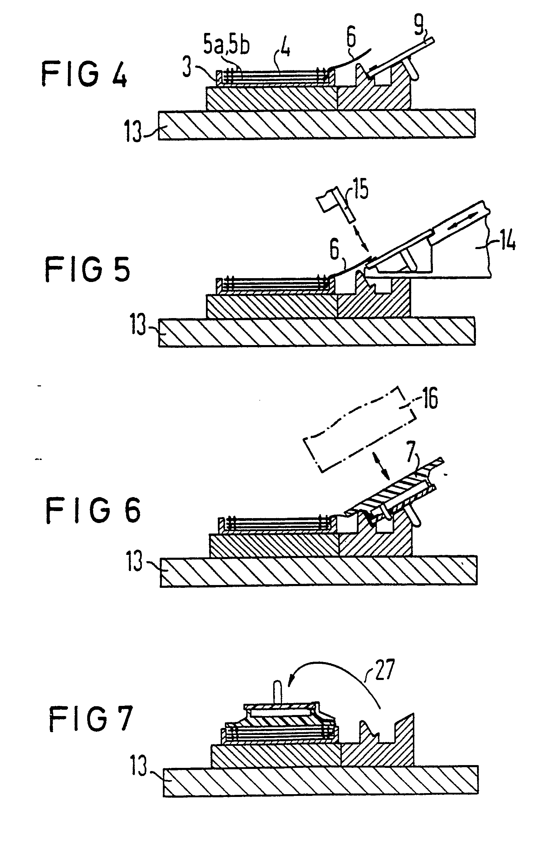

In der Figur 4 ist schematisch die Vormontage angedeutet. Ein Werkstückträger 13 umfaßt die Einheit der konstruktiven Halteelemente, die Trennplatte 3, die Silikonringe 5a und 5b und die Wandlerplatte 4 mit Anschlußbändchen 6. Der rechte Teil des Werkstückträgers ist für die Aufnahme der Verstärkerflachbaugruppe 9 ausgebildet.

Gegenüber der Figur 4 zeigt die Figur 5 zusätzlich eine Aushebevorrichtung 14 zum Ausheben der Verstärkerbaugruppe in die Lötposition. Ferner ist ein Reflowlötkopf 15 angedeutet.

Gegenüber der Darstellung in Figur 4 zeigt die Figur 6 zusätzlich den Trägerzuführ- und Montagestempel 16 in abgehobener Position, nachdem der Träger aufgesetzt wurde.

In der Figur 7 ist schematisch eine Zusatzvorrichtung 17 angedeutet, die den Träger mit Verstärkerflachbaugruppe in Pfeilrichtung verschwenkt und in die Einheit der konstruktiven Halteelemente und Wandlerplatte montiert.

Der Montagevorgang läuft zum Beispiel folgendermaßen ab :

In einer Station einer Transferstraße wird der Werkstückträger 13 mit der Einheit der konstruktiven Halteelemente und der Verstärkerbaugruppe bestückt (Figur 4). Dieser Vorgang kann automatisch erfolgen. In einer weiteren Transferstation, der Lötstation (Figur 5), wird die Verstärkerflachbaugruppe durch eine Zusatzeinrichtung in die Lötposition ausgehoben, um damit die für die spätere Montage notwendige Bändchenlage zu erhalten, der Reflowlötkopf 15 auf die Lötstelle abgesenkt und die Lötung der Anschlußbändchen auf den Leiterbahnen zeit- und temperaturgesteuert automatisch ausgeführt. Danach wird die Verstärkerflachbaugruppe wieder in den Werkstückträger abgesenkt.

In einer nächsten Station (Figur 6) wird der Trägerzuführ- und Montagestempel in einer Zusatzvorrichtung bereitgehalten und automatisch auf die Verstärkerflachbaugruppe über Haltepimpel aufgedrückt.

Nach einem weiteren Transport in eine neue Transferstation (Figur 7) wird dort die Einheit Träger mit Verstärkerflachbaugruppe mit Hilfe einer zusätzlichen Vorrichtung geschwenkt und in die Einheit konstruktive Halteelemente und Wandlerplatte montiert.

Den Abschluß bildet in einer weiteren, nicht dargestellten Station das automatische Aufkleben des Etiketts 10a zur Bändchenisolierung.

**Patentansprüche**

1. Piezoelektrisch-akustischer Wandler für elektroakustische Kapseln mit zwei Anschlußelementen in Form von Anschlußbändchen (6) bzw. -drähten für den Wandler, von denen das eine an der kleberseitigen Elektrode der Piezokeramik kontaktiert und das zweite an der anderen Elektrode aufgelötet ist, dadurch gekennzeichnet, daß die nicht mit der Wandlerplatte verbundenen Enden der Anschlußbändchen auf Leiterbahnen (12) einer Verstärkerflachbaugruppe (9) angelötet sind.

2. Wandler nach Anspruch 1, dadurch gekennzeichnet, daß die Anschlußstellen für die Bändchen (6) einen Toleranzbereich für das Anlöten zulassen.

3. Vorrichtung zum Anlöten der Anschlußbändchen auf den Leiterbahnen einer Verstärkerflachbaugruppe und zum Montieren dieser Flachbaugruppe auf der Trägerplatte eines piezoelektrisch-akustischen Wandlers nach Anspruch 1 und 2, dadurch gekennzeichnet, daß ein Werkstückträger (13) für die Einheit konstruktiver Halteelemente und Wandlerplatte (3) und die Verstärkerflachbaugruppe (9) vorgesehen ist, auf dem die Leiterbahnen (12) für die Kontaktierung der Anschlußbändchen (6) frei zugänglich sind.

4. Vorrichtung nach Anspruch 3, dadurch gekennzeichnet, daß auf dem Werkstückträger (13) die Flachbaugruppe (9) in einem bestimmten Winkel zu der Einheit konstruktiver Halteelemente und Wandlerplatte angeordnet ist.

5. Vorrichtung nach den Ansprüchen 3 und 4, durch gekennzeichnet, daß die Wandlerplatte (3) aus der Vorrichtung durch eine Zusatzvorrichtung in eine definierte Lötposition ausgehoben ist (Figur 5).

6. Vorrichtung nach Anspruch 5, dadurch gekennzeichnet, daß eine Reflowlötvorrichtung (15) vorgesehen ist, die in dieser Position die Bändchen (6) an der Leiterplatte kontaktiert.

7. Vorrichtung nach den Ansprüchen 3 bis 6, dadurch gekennzeichnet, daß in einem weiteren Vorrichtungsteil (16) der Leiterplattenträger vorbereitend angeordnet ist, mit dem er von oben auf die Flachbaugrupe (9) aufgesteckt werden kann.

8. Vorrichtung nach den Ansprüchen 3 bis 7, dadurch gekennzeichnet, daß ein weiteres Vorrichtungsteil angeordnet ist, das die Kombination Träger-Verstärkerflachbaugruppe in einer bestimmten Bahn schwenkt und auf die Einheit konstruktive Halteelemente und Wandlerplatte aufsetzt und dabei die an die Verstärkerflachbaugruppe angelöteten Bändchen in bestimmter Weise ausformt.

9. Vorrichtung nach den Ansprüchen 3 bis 5, dadurch gekennzeichnet, daß eine weitere Montagevorrichtung vorgesehen ist, in der ein Klebeetikett (10a) aufgebracht wird, das die beiden Anschlußbändchen (6) gegen das Metallgehäuse isoliert.

## Claims

1. A piezo-electric-acoustic transducer for electro-acoustic capsules comprising two terminal elements in the form of terminal strips or wires (6) for the transducer, one of which is contacted to the adhesive-side electrode of the piezo-ceramic and the second of which is soldered to the other electrode, characterised in that those ends of the terminal strips which are not connected to the transducer plate are soldered to conductor paths (12) of an amplifier flat assembly (9).

2. A transducer as claimed in Claim 1, characterised in that the terminal positions for the strips (6) leave a tolerance range for soldering.

3. A device for soldering the terminal strips to the conductor paths of an amplifier flat assembly and for assembling this flat assembly on the carrier plate of a piezo-electric-acoustic transducer as claimed in Claim 1 and 2, characterised in that a workpiece carrier (13) is provided for the unit composed of structural support elements and transducer plate (3) and the amplifier flat assembly (9), on which carrier the conductor paths (12) are freely accessible for the contacting of the terminal strips (6).

4. A device as claimed in Claim 3, characterised in that on the workpiece carrier (13) the flat assembly (9) is arranged at a specific angle to the unit consisting of structural support elements and transducer plate.

5. A device as claimed in Claims 3 and 4, characterised in that the transducer plate (3) is lifted out of the device into the soldering position by means of an additional device (Fig. 5).

6. A device as claimed in Claim 5, characterised in that a reflow soldering device (15) is provided which, in this position, contacts the strips (6) to the circuit board.

7. A device as claimed in Claims 3 to 6, characterised in that the circuit board carrier is preparatorily arranged in a further device component (16) by means of which it can be positioned onto the flat assembly (9) from above.

8. A device as claimed in Claims 3 to 7, characterised in that a further device component is provided by which the combination of the carrier-amplifier flat assembly is pivotted in a specific path and positioned onto the unit consisting of structural support elements and transducer plate, whereby the strips soldered to the amplifier flat assembly are shaped in a specific manner.

9. A device as claimed in Claims 3 to 5, characterised in that a further assembly device is provided in which an adhesive label (10a) is applied which serves to insulate the two terminal strips (6) from the metal housing.

## Revendications

1. Transducteur piézoélectrique-acoustique pour capsules électroacoustiques, présentant deux éléments de connexion sous forme de bandelettes (6) ou de fils de connexion pour le transducteur, dont l'un est mis en contact avec l'électrode côté adhésif de la céramique piézoélectrique et le deuxième est brasé sur l'autre électrode, caractérisé en ce que les extrémités des bandelettes non reliées à la plaque du transducteur sont brasées sur des pistes conductives (12) d'un sous-ensemble plat (9) constituant un amplificateur.

2. Transducteur selon la revendication 1, caractérisé en ce que les points de connexion pour les bandelettes (6) présentent une zone de tolérance pour le brasage.

3. Dispositif pour braser les bandelettes sur les pistes conductives d'un sous-ensemble plat constituant un amplificateur et pour monter ce sous-ensemble sur la plaque support d'un transducteur piézoélectrique-acoustique selon la revendication 1 ou 2, caractérisé en ce qu'il comprend un porte-pièce (13) pour l'unité composée des éléments de maintien de la construction, de la plaque (3) du transducteur et du sous-ensemble plat (9) formant amplificateur, porte-pièce sur lequel les pistes conductives (12) sont librement accessibles pour le raccordement des bandelettes de connexion (6).

4. Dispositif selon la revendication 3, caractérisé en ce que sur le porte-pièce (13), le sous-ensemble plat (9) est disposé sous un angle déterminé par rapport à l'unité éléments de maintien et plaque du transducteur.

5. Dispositif selon les revendications 3 et 4, caractérisé en ce qu'un dispositif additionnel relève la plaque du transducteur (3) du dispositif à une position de brasage définie (Fig. 5).

6. Dispositif selon la revendication 5, caractérisé en ce qu'il utilise un appareil à braser par onde de brasure (15) qui, dans cette position, raccorde les bandelettes (6) à la plaque de circuit imprimé.

7. Dispositif selon les revendications 3 à 6, caractérisé en ce que le support de la plaque de circuit imprimé est disposé en préparation dans une autre partie (16) du dispositif, par laquelle ce support peut être fixé d'en haut, par emboîtement, sur le sous-ensemble plat (9).

8. Dispositif selon les revendications 3 à 7, caractérisé en ce qu'il comprend une partie additionnelle qui retourne la combinaison formée par le support et le sous-ensemble amplificateur suivant une trajectoire déterminée, qui la pose sur l'unité comprenant les éléments de maintien et la plaque de transducteur et qui, dans cette opération, déforme de manière déterminée les bandelettes brasées sur le sous-ensemble amplificateur.

9. Dispositif selon les revendications 3 à 5, caractérisé en ce qu'il comprend un dispositif de montage supplémentaire, dans lequel s'effectue la mise en place d'une étiquette collante (10a) qui isole les deux bandelettes de connexion (6) vis-à-vis du boîtier métallique.

# FIG 1

# FIG 2

# FIG 3

FIG 4

FIG 5

FIG 6

FIG 7